# EUROPÄISCHE PATENTSCHRIFT

(11) **EP 0 666 645 B1**
(45) Veröffentlichungstag und Bekanntmachung des Hinweises auf die Patenterteilung: **20.10.1999**
(21) Anmeldenummer: 95101329.1
(22) Anmeldetag: 01.02.1995
(51) Int. Cl.: H03H 11/24, H03G 3/00

(54) **Schaltungsanordnung mit einer Verstärkerschaltung mit einstellbarer Verstärkung**
Circuit with gain control
Circuit comportant une commande de gain

(30) Priorität: 04.02.1994 DE 4403388
(43) Veröffentlichungstag der Anmeldung: 09.08.1995
(73) Patentinhaber: TEMIC Semiconductor GmbH, 74072 Heilbronn (DE)
(72) Erfinder: Gutsch, Henrik, Dr., D-74081 Heilbronn (DE); Häfner, Horst, D-74080 Heilbronn (DE); Hammel, Hermann, D-74585 Rot am See (DE); Schnabel, Jürgen, D-74211 Leingarten (DE)
(74) Vertreter: Maute, Hans-Jürgen, Dipl.-Ing.

(56) Entgegenhaltungen:
- EP-A- 0 350 155
- EP-A- 0 555 905
- DE-A- 4 316 553
- US-A- 5 180 988

## Beschreibung

Die Erfindung betrifft eine Schaltungsanordnung nach dem Oberbegriff des Anspruchs 1.

Eine derartige Schaltungsanordnung ist beispielsweise aus der EP 0 350 155 A2 bekannt. Die bekannte Schaltungsanordnung weist eine Verstärkerschaltung, eine der Verstärkerschaltung vorgeschaltete Eingangsschaltung mit mehreren Emitterfolgern und eine Steuerschaltung auf. Die Verstärkerschaltung ist hierbei als sogenannte Gilbertzelle mit zwei Steuereingängen ausgeführt, denen jeweils eine Steuerspannung zur Einstellung der Verstärkung zugeführt wird. die Steuerspannungen werden mittels der Steuerschaltung erzeugt, welche hierzu einen Digitalanalogwandler sowie eine Regelschaltung aufweist. Der Digitalanalogwandler erzeugt dabei aus einer Referenzspannung und digitalen Steuersignalen zwei Ströme, die der Regelschaltung zugeführt werden, welche daraus die beiden Steuerspannungen erzeugt und die Arbeitspunkte dieser Steuerspannungen auf die gewünschten Werte regelt.

Als nachteilig erweist sich hierbei der aufgrund des hohen Schaltungsaufwands erforderliche hohe Platzbedarf sowie die Empfindlichkeit des Regelkreises gegenüber eingekoppelten Störungen.

Der Erfindung liegt die Aufgabe zugrunde, eine Schaltungsanordnung nach dem Oberbegriff des Anspruchs 1 anzugeben, die einen einfachen Aufbau aufweist und die in der Herstellung kostengünstig ist.

Diese Aufgabe wird erfindungsgemäß durch die Merkmale im Kennzeichen des Patentanspruchs 1 gelöst. Vorteilhafte Ausgestaltungen und Weiterbildungen der Erfindung ergeben sich aus den Unteransprüchen.

Bei der Schaltungsanordnung der Erfindung enthält die Verstärkerschaltung mindestens einen Steueranschluß zur Einstellung der Verstärkung und eine Steuerschaltung, die mindestens einen Referenzeingang, mehrere digitale Steuereingänge und mindestens einen Steuerausgang aufweist.

Die Steuerschaltung ist an einem Steuerausgang mit einem Steueranschluß der Verstärkerschaltung verbunden und liefert das Steuersignal zur Einstellung der Verstärkung der Verstärkerschaltung. Sie ist vorzugsweise als Stromspiegelschaltung mit MOS-Transistoren ausgeführt und besteht aus einem Referenznetzwerk und einem damit verbundenen Spiegelnetzwerk. Das Referenznetzwerk weist einen Referenzzweig und parallel mit dem Referenzzweig verbundene Steuerzweige auf. Es wird von einem über einen Versorgungsanschluß, welcher mit dem Referenzeingang der Steuerschaltung verbunden ist, eingespeisten Referenzsignal - vorzugsweise von einem Referenzstrom - versorgt. Das Spiegelnetzwerk, welches neben einem Spiegelzweig mindestens einen parallel dazu geschalteten Steuerzweig enthält, liefert an einem Stromspiegelausgang, welcher mit dem Steuerausgang der Steuerschaltung verbunden ist, das Steuersignal - vorzugsweise den Steuerstrom - der Steuerschaltung. Der Referenzzweig ist als Spiegelstromsenke, der Spiegelzweig als Spiegelstromquelle ausgebildet. Die Steuerzweige, welche jeweils mindestens einen Steueranschluß aufweisen, sind als schaltbare Spiegelstromquellen ausgeführt. Jeweils ein Steueranschluß eines Steuerzweigs ist mit jeweils einem digitalen Steuereingang der Steuerschaltung verbunden.

Durch die Ansteuerung der Steuerzweige werden neben den Strompfaden im Referenzzweig und im Spiegelzweig zusätzliche Strompfade im Referenznetzwerk oder im Spiegelnetzwerk hinzu- oder abgeschaltet, was eine Änderung des Spiegelverhältnisses der Stromspiegelschaltung zur Folge hat. Somit kann der Ausgangsstrom der Steuerschaltung - der Steuerstrom - über die an den digitalen Steuereingängen angelegten Steuersignale in diskreten Stufen, d. h. digital eingestellt werden. Eine analoge Einstellung des Steuerstroms, zum Beispiel eine Feineinstellung, erfolgt durch Verändern des über den Referenzeingang der Steuerschaltung eingespeisten Stromes.

In einer Schaltungserweiterung wird in der Eingangsschaltung das dieser über deren Eingangsanschluß zugeführte Signal zu vorzugsweise zwei unterschiedlichen Netzwerken verzweigt. Die Ausgänge dieser Netzwerke sind an jeweils einen Eingangsanschluß von vorzugsweise zwei in der Verstärkerschaltung vorgesehenen Verstärkerstufen, deren Verstärkung über jeweils einen Verstärkersteuereingang einstellbar ist, angeschlossen. Die Verstärkerstufen weisen jeweils einen Ausgangsanschluß auf, die an einem gemeinsamen Ausgangsanschluß der Verstärkerschaltung miteinander verbunden sind. Die Einstellung der Verstärkung erfolgt in diesem Falle über eine in der Verstärkerschaltung vorgesehene Überblendstufe, welche vorzugsweise zwei mit jeweils einem Verstärkersteuereingang der Verstärkerstufen verbundene Uberblendausgänge aufweist.

Diese Schaltungserweiterung eignet sich insbesondere zur Einstellung der Verstärkung im Empfangszweig eines Telefonschaltkreises. Hierzu wird die Telefonleitung - im folgenden Leitung genannt - an den Eingangsanschluß der Eingangsschaltung angeschlossen. Die beiden unterschiedlichen Netzwerke sind in diesem Fall als Rückhörnetzwerke ausgeführt, von denen das eine an den Grenzfall der langen und das andere an den Grenzfall der kurzen Leitung angepaßt ist. Es ist somit möglich, auf einfache Weise durch Überblendung die Verstärkung der Verstärkerstufen so einzustellen, daß möglichst gute Rückhöreigenschaften unabhängig von der Leitungslänge erreichbar sind.

Die erfindungsgemäße Schaltungsanordnung vereinigt mehrere Vorteil in sich:
- Die Verstärkung kann digital eingestellt werden, d. h., die Anpassung an andere Anforderungen, andere Eingangs- und Ausgangsbeschaltungen kann ohne zusätzliche Bauteile kostengünstig durchgeführt werden.
- Die Schaltungsanordnung ist bestens für die Verwendung in integrierten Schaltungen geeignet, da keine externe Bauteile zur Einstellung der Verstärkung benötigt werden.
- Durch Variieren des am Referenzeingang angelegten Referenzsignals ist zudem eine analoge Einstellung, zum Beispiel eine Feineinstellung der Verstärkung, möglich.
- Bei einer Integration der Schaltungsanordnung auf einem IC ist das Verhältnis der Genauigkeit des eingestellten Steuerstromes zur dazu benötigten Chipfläche wegen der Einstellung des Spiegelverhältnisses durch Ansteuerung sowohl des Referenznetzwerks als auch des Spiegelnetzwerks besonders günstig.
- Bei einer Schaltungsanordnung mit zwei Verstärkerstufen kann die Überblendung und somit die Anpassung an unterschiedlich lange Leitungen automatisch, zum Beispiel in Abhängigkeit des Leitungsstromes oder digital über eine Ansteuerschaltung erfolgen.

Die erfindungsgemäße Schaltungsanordnung läßt sich überall dort einsetzen, wo die Verstärkung einer Verstärkerschaltung auf einfache Weise und kostengünstig eingestellt oder verändert werden muß.

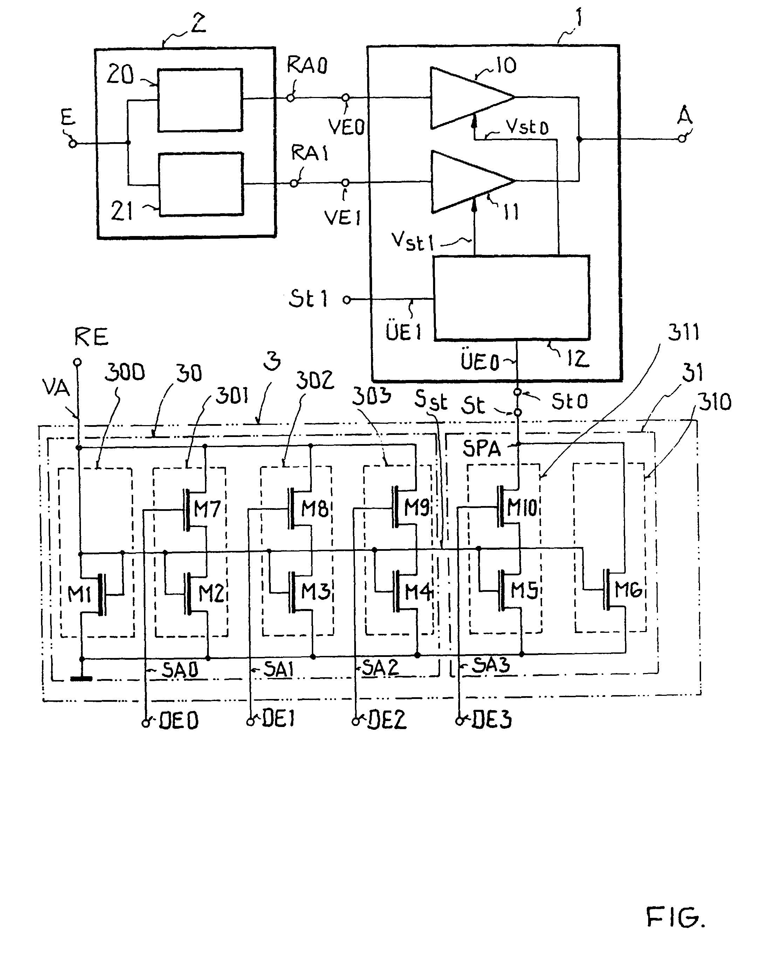

Die Erfindung wird im folgenden anhand dem in der Figur dargestellten Schaltbild eines Ausführungsbeispiels näher beschrieben. Es handelt sich hierbei um eine auf einem IC integrierte Schaltungsanordnung zur digitalen Verstärkungseinstellung im Empfangszweig eines Telefonschaltkreises. Die Figur zeigt, daß die Schaltungsanordnung im wesentlichen aus den drei miteinander verbundenen Schaltungsteilen Verstärkerschaltung 1, Eingangsschaltung 2 und Steuerschaltung 3 besteht.

Die Verstärkerschaltung 1 weist zwei Verstärkereingänge VE0 bzw. VE1, zwei Steueranschlüsse St0 bzw. St1 und einen Verstärkerausgang A auf. Sie enthält zwei Verstärkerstufen 10 bzw. 11 mit einstellbarer Verstärkung, die je einen Eingangsanschluß, je einen Ausgangsanschluß und je einen Verstärkersteuereingang Vst0 bzw. Vst1 zur Einstellung der Verstärkung aufweisen, und eine Überblendstufe 12 mit zwei Überblendeingängen ÜE0 bzw. ÜE1 und zwei Überblendausgängen. Die Eingangsanschlüsse der Verstärkerstufen 10 bzw. 11 sind jeweils mit einem Verstärkereingang VE0 bzw. VE1 der Verstärkerschaltung 1, die Ausgangsanschlüsse mit dem Verstärkerausgang A der Verstärkerschaltung 1 und die Verstärkersteuereingänge Vst0 und Vst1 mit jeweils einem Überblendausgang der Überblendstufe 12 verbunden. Die Überblendeingänge ÜE0 bzw. ÜE1 der Überblendstufe 12 sind jeweils an einen Steueranschluß St0 bzw. St1 der Verstärkerschaltung 1 angeschlossen.

Die Eingangsschaltung 2 verfügt über einen Eingangsanschluß E und zwei Ausgangsanschlüsse RA0 und RA1. Das über den Eingangsanschluß E empfangene Signal wird in der Eingangsschaltung 2 zu den Eingangsanschlüssen von zwei Netzwerken 20 und 21, von denen üblicherweise das eine an den Grenzfall der kurzen Leitung und das andere an den Grenzfall der langen Leitung angepaßt ist, verzweigt. Die Ausgangsanschlüsse der Eingangsschaltung RA0 bzw. RA1 sind jeweils mit einem Ausgang der Netzwerke 20 bzw. 21 verbunden. Jeweils ein Verstärkereingang VE0 bzw. VE1 der Verstärkerschaltung 1 ist an jeweils einem Ausgangsanschluß RA0 bzw. RA1 der Eingangsschaltung 2 angeschlossen.

Die Steuerschaltung 3 weist einen Steuerausgang St, einen Referenzeingang RE und digitale Steuereingänge DE0, DE1, DE2 und DE3 auf. Sie ist als Stromspiegelschaltung mit einem Referenznetzwerk 30 und einem Spiegelnetzwerk 31 ausgeführt.

Das Referenznetzwerk 30 besteht aus einem Referenzzweig 300 und parallel dazu geschalteten Steuerzweigen 301, 302 und 303. Der Referenzzweig 300 weist einen Versorgungsanschluß VA, der mit dem Referenzeingang RE der Steuerschaltung 3 verbunden ist, auf. Er enthält einen MOS-Transistor M₁, der als Spiegelstromsenke der Stromspiegelschaltung beschaltet ist. Bei den Steuerzweigen 301 bzw. 302 bzw. 303 handelt es sich um Spiegelstromquellen, die schaltbar ausgeführt sind. Sie weisen jeweils einen Steueranschluß SA0 bzw. SA1 bzw. SA2 auf, der mit jeweils einem digitalen Steuereingang DE0 bzw. DE1 bzw. DE2 der Steuerschaltung 3 verbunden ist. Die Steuerzweige 301 bzw. 302 bzw. 303 bestehen jeweils aus einem MOS-Transistor M₂ bzw. M₃ bzw. M₄, der als Spiegelstromquelle beschaltet ist, und dem jeweils ein Schalttransistor M₇ bzw. M₈ bzw. M₉ vorgeschaltet ist. Die Ansteuerung der Steuerzweige 301 bzw. 302 bzw. 303 erfolgt über die Steueranschlüsse der Schalttransistoren M₇ bzw. M₈ bzw. M₉, die jeweils als die Steueranschlüsse SA0 bzw. SA1 bzw. SA2 der Steuerzweige 301 bzw. 302 bzw. 303 ausgebildet sind. Die Steuerzweige 301, 302 und 303 sind am Versorgungsanschluß VA des Referenzzweigs 300 miteinander verbunden.

Das Spiegelnetzwerk 31 besteht aus einem Spiegelzweig 310 und einem parallel dazu geschalteten Steuerzweig 311. Der Spiegelzweig 310 weist einen Stromspiegelausgang SPA auf, der mit dem Steuerausgang St der Steuerschaltung 3 verbunden ist. Er enthält einen MOS-Transistor M₆, der als Spiegelstromquelle der Stromspiegelschaltung beschaltet ist. Der Steuerzweig 311 ist in der gleichen Art wie die Steuerzweige 301, 302 und 303 ausgeführt. Er enthält einen MOS-Transistor M₅, der als Spiegelstromquelle beschaltet ist und einen ihm vorgeschalteten Schalttransistor M₁₀, dessen Steueranschluß als Steueranschluß SA3 des Steuerzweigs 311 ausgeführt ist, und der an den digitalen Steuereingang DE3 angeschlossen ist. Der Steuerzweig 311 ist am Stromspiegelausgang SPA mit dem Spiegelzweig 310 verbunden.

Die Schalttransistoren M₇ bzw. M₈ bzw. M₉ bzw. M₁₀ der Steuerzweige 301 bzw. 302 bzw. 303 bzw. 311 sind als MOS-Transistoren ausgebildet. Die Source-Anschlüsse der MOS-Transistoren M₁, M₂, M₃, M₄, M₅, M₆ liegen alle auf Massepotential.

Die Ansteuerung der Verstärkerschaltung 1 erfolgt über den Steueranschluß St0, der mit dem Steuerausgang St der Steuerschaltung 3 verbunden ist. Die Steuerschaltung 3 wird über den Referenzeingang RE mit einem Referenzstrom versorgt. In Abhängigkeit von dem an den digitalen Steuereingängen DE1, DE1, DE2 und DE3 angelegten digitalen Steuersignalen, wird über den Steuerausgang St ein zum Referenzstrom proportionaler Steuerstrom in die Verstärkerschaltung 1 eingespeist. Der Proportionalitätsfaktor - das Spiegelverhältnis - hängt von den Logikpegeln der digitalen Steuersignale ab, da durch Ansteuerung der Steuerzweige 301, 302, 303 und 311 neben einem Strompfad durch den Referenzzweig 300 und einem Strompfad durch den Spiegel zweig 310 weitere Strompfade im Referenznetzwerk 30 bzw. Spiegelnetzwerk 31 geschlossen oder geöffnet werden, wodurch das Spiegelverhältnis variiert wird. Das Spiegelverhältnis hängt außerdem auch von der Größe der MOS-Transistoren M₁, M₂, M₃, M₄, M₅, M₆ ab.

In der Überblendstufe 12 der Verstärkerschaltung 1, welche beispielsweise als Differenzverstärkerstufe ausgeführt ist, wird der Steuerstrom in zwei Teilströme aufgeteilt, die jeweils eine der beiden Verstärkerstufen 10 bzw. 11 ansteuern. Mit einem am Steueranschluß St1 der Verstärkerschaltung 1 angelegten Steuersignal kann das Überblendverhältnis eingestellt werden. Falls die beiden Verstärkerstufen 10 und 11 die gleiche lineare Abhängigkeit der Verstärkung vom Steuerstrom aufweisen, wird durch die Überblendung die Gesamtverstärkung nicht verändert. Durch die Überblendung ist eine Anpassung an die am Eingangsanschluß E der Eingangsschaltung 2 vorliegenden Gegebenheiten, zum Beispiel eine Anpassung an die Leitungslänge einer am Eingangsanschluß E angeschlossenen Leitung, erreichbar.

Eine einfachere Schaltungsanordnung, jedoch ohne Überblendmöglichkeit, ergibt sich, wenn die Eingangsschaltung 2 mit nur einem Netzwerk 20 und die Verstärkerschaltung 1 mit nur einer Verstärkerstufe 10 ausgeführt wird. Die Überblendstufe 12 kann wegfallen oder zur weiteren Beeinflussung des Steuerstroms, z. B. als zusätzliche Verstärkerstufe, beibehalten werden.

## Patentansprüche

1. Schaltungsanordnung mit:
- einer verstärkerschaltung (1) mit einstellbarer Verstärkung, die mindestens einen Verstärkereingang (VE0, VE1), mindestens einen Verstärkerausgang (A) und mindestens einen Steueranschluß (St0, St1) zur Einstellung der Verstärkung aufweist,
- einer Eingangsschaltung (2) mit einem Eingangsanschluß (E) und mit mindestens einem Ausgangsanschluß (RA0, RA1), die über mindestens einen Ausgangsanschluß (RA0, RA1) mit jeweils einem Verstärkereingang (VE0, VE1) der Verstärkerschaltung (1) verbunden ist,
- einer Steuerschaltung (3), die mindestens einen mit dem mindestens einen Steueranschluß (St0) der Verstärkerschaltung (1) verbundenen Steuerausgang (St) aufweist, an dem ein Steuerstrom zur Einstellung der Verstärkung der Verstärkerschaltung (1), ansteht, und die mindestens einen Referenzeingang (RE) und digitale Steuereingänge (DE0), DE1, DE2, DE3) aufweist,
dadurch gekennzeichnet, daß
die Steuerschaltung (3) als Stromspiegelschaltung mit dem Referenzeingang (RE) als Eingang für einen Referenzstrom und dem mindestens einen Steuerausgang (St) als Ausgang für den Steuerstrom ausgeführt ist, die einen mit dem Referenzeingang (RE) verbundenen Referenzzweig (300), einen mit dem mindestens einen Steuerausgang (St) verbundenen Spiegelzweig (310) und mindestens einen zum Referenzzweig (300) oder Spiegelzweig (310) parallel geschalteten Steuerzweig (301, 302, 303, 311) aufweist, wobei in dem mindestens einen Steuerzweig (301, 302, 303, 311) und dem Spiegelzweig (310) jeweils eine durch den Referenzzweig (300) gesteuerte Spiegelstromquelle (M₂...M₆) zur Erzeugung jeweils eines zum Referenzstrom proportionalen Stromes vorgesehen ist, und wobei die Spiegelstromquelle (M₂...M₅) des mindestens einen Steuerzweiges (301, 302, 303, 311) über einen digitalen Steuereingang (DE0...DE3) der Steuerschaltung (3) ein- und ausschaltbar ist.

2. Schaltungsanordnung nach Anspruch 1, dadurch gekennzeichnet, daß die Steuerschaltung (3) mehrere Steuerzweige (301, 302, 303, 311) aufweist, von denen einige zum Referenzzweig (300) und die verbleibenden zum spiegelzweig (310) parallel geschaltet sind.

3. Schaltungsanordnung nach Anspruch 1 oder 2, dadurch gekennzeichnet, daß
- der Referenzzweig (300) einen als Spiegelstromsenke der Stromspiegelschaltung beschalteten Stromsenkentransistor (M₁) aufweist,
- der Spiegelzweig (310) einen als Spiegelstromquelle der Stromspiegelschaltung beschalteten Stromquellentransistor (M₆) aufweist,
- jeder Steuerzweig (301 bzw. 302 bzw. 303 bzw. 311) einen Schalttransistor (M₇ bzw. M₈ bzw. M₉ bzw. M₁₀) aufweist, dem ein als Spiegelstromquelle der Stromspiegelschaltung ausgeführter Stromquellentransistor (M₂ bzw. M₃ bzw. M₄ bzw. M₅) nachgeschaltet ist.

4. Schaltungsanordnung nach Anspruch 3, dadurch gekennzeichnet, daß die Transistoren (M₁, M₂, M₃, M₄, M₅, M₆, M₇, M₈, M₉, M₁₀) des Referenzzweigs (300), der Steuerzweige (301, 302, 303, 311) und des Spiegelzweigs (310) als MOS-Transistoren ausgeführt sind.

5. Schaltungsanordnung nach einem der vorherigen Ansprüche, dadurch gekennzeichnet, daß
- die Verstärkerschaltung (1) eine Verstärkerstufe (10) mit einem als ein verstärkereingang (VE0) der Verstärkerschaltung (1) ausgeführten Eingangsanschluß, mit einem als ein Steueranschluß (St0) der Verstärkerschaltung (1) ausgeführten Verstärkersteuereingang (Vst0) und einem als Verstärkerausgang (A) der Verstärkerschaltung (1) ausgeführten Ausgangsanschluß aufweist und
- die Eingangsschaltung (2) ein Netzwerk (20) mit einem als Eingangsanschluß (E) der Eingangsschaltung (2) ausgeführten Eingangsanschluß und einem als Ausgangsanschluß (RAO) der Eingangsschaltung (2) ausgeführten Ausgangsanschluß aufweist.

6. Schaltungsanordnung nach einem der Ansprüche 1 bis 4, dadurch gekennzeichnet, daß
- die Verstärkerschaltung (1) mindestens zwei Verstärkerstufen (10, 11) und eine Überblendstufe (12) aufweist,
- die Verstärkerstufen (10 bzw. 11) jeweils einen Verstärkersteuereingang (Vst0 bzw. Vst1), jeweils einen mit jeweils einem Verstärkereingang (VE0 bzw. VE1) verbundenen Eingangsanschluß und jeweils einen mit einem Verstärkerausgang (A) verbundenen Ausgangsanschluß aufweisen,
- die Überblendstufe (12) mindestens zwei mit jeweils einem Verstärkersteuereingang (Vst0 bzw. Vst1) der Verstärkerstufen (10 bzw. 11) verbundene Überblendausgänge und mindestens zwei mit jeweils einem Steueranschluß (St0 bzw. St1) verbundene Überblendeingänge (ÜE0 bzw. ÜE1) aufweist.

7. Schaltungsanordnung nach Anspruch 6, dadurch gekennzeichnet, daß
- die Eingangsschaltung (2) mindestens zwei Netzwerke (20 bzw. 21) mit je einem Eingangsanschluß und mit je einem Ausgangsanschluß aufweist,
- die Eingangsanschlüsse der Netzwerke (20, 21) der Eingangsschaltung (2) am Eingangsanschluß (E) der Eingangsschaltung (2) miteinander verbunden sind,
- jeweils ein Ausgangsanschluß der Netzwerke (20 bzw. 21) an jeweils einem Ausgangsanschluß (RA0 bzw. RA1) der Eingangsschaltung mit jeweils einem Verstärkereingang (VE0 bzw. VE1) verbunden ist.

8. Schaltungsanordnung nach Anspruch 6, dadurch gekennzeichnet, daß die Überblendstufe (12) als Differenzverstärkerstufe ausgeführt ist.

9. Schaltungsanordnung nach Anspruch 8, dadurch gekennzeichnet, daß die Überblendstufe (12) durch den am Elngangsanschluß (E) in die Eingangsschaltung (2) fließenden Strom ansteuerbar ist.

10. Schaltungsanordnung nach einem der Ansprüche 6 oder 8, dadurch gekennzeichnet, daß die Überblendstufe (12) durch mindestens ein digital erzeugtes Steuersignal ansteuerbar ist.

11. Schaltungsanordnung nach einem der vorherigen Ansprüche, dadurch gekennzeichnet, daß die Netzwerke (20, 21) der Eingangsschaltung (2) als Rückhörnetzwerke eines Telefonschaltkreises ausgeführt sind und die Schaltungsanordnung als Empfangsverstärker in einem Telefonschaltkreis eingesetzt wird.

## Claims

1. A circuit arrangement comprising:
- an amplifier circuit (1) with adjustable amplification having at least one amplifier input (VE0, VE1), at least one amplifier output (A), and at least one control terminal (St0, St1) for adjusting the amplification,
- an input circuit (2), having an input terminal (E) and at least one output terminal (RA0, RA1), which is in each case connected to an amplifier input (VE0, VE1) of the amplifier circuit (1) via at least one output terminal (RA0, RA1),
- a control circuit (3) having at least one control output (St) which is connected to the at least one control terminal (St0) of the amplifier circuit (1) and at which a control current for adjusting the amplification of the amplifier circuit (1) is available, and having at least one reference input (RE) and digital control inputs (DE0, DE1, DE2, DE3),
characterised in that the control circuit (3) has the form of a current mirror circuit with the reference input (RE) as input for a reference current and the at least one control output (St) as output for the control current, and comprising a reference branch (300) connected to the reference input (RE), a mirror branch (310) connected to the at least one control output (St), and at least one control branch (301, 302, 303, 311) connected in parallel to the reference branch (300) or mirror branch (310), where a mirror current source (M₂ ...M₆), controlled by the reference branch (300), in each case for generating a current proportional to the reference current is in each case provided in the at least one control branch (301, 302, 303, 311) and the mirror branch (310), and where the mirror current source (M₂...M₅) of the at least one control branch (301, 302, 303, 311) can be switched on and off via a digital control input (DE0...DE3) of the control circuit (3).

2. A circuit arrangement according to Claim 1,
characterised in that the control circuit (3) comprises a plurality of control branches (301, 302, 303, 311), of which some are connected in parallel to the reference branch (300) and the remainder are connected in parallel to the mirror branch (310).

3. A circuit arrangement according to Claim 1 or 2, characterised in that
- the reference branch (300) comprises a current sink transistor (M₁) connected as mirror current sink of the current mirror circuit,
- the mirror branch (310) comprises a current source transistor (M₆) connected as mirror current source of the current mirror circuit,
- each control branch (301; 302; 303, 311) comprises a switching transistor (M₇; M₈, M₉; M₁₀), downstream of which a current source transistor (M₂; M₃; M₄; M₅), formed as mirror current source of the current mirror circuit, is connected.

4. A circuit arrangement according to Claim 3,
characterised in that the transistors (M₁, M₂, M₃, M₄, M₅, M₆, M₇, M₈, M₉, M₁₀) of the reference branch (300), of the control branches (301, 302, 303, 311) and of the mirror branch (310) have the form of MOS transistors.

5. A circuit arrangement according to one of the preceding claims, characterised in that
- the amplifier circuit (1) comprises an amplifier stage (10) having an input terminal in the form of an amplifier input (VE0) of the amplifier circuit (1), an amplifier control input (Vst0) in the form of a control terminal (St0) of the amplifier circuit (1), and an output terminal in the form of an amplifier output (A) of the amplifier circuit (1) and
- the input circuit (2) comprises a network (20) having an input terminal in the form of the input terminal (E) of the input circuit (2) and an output terminal in the form of the output terminal (RA0) of the input circuit (2).

6. A circuit arrangement according to one of Claims 1 to 4, characterised in that
- the amplifier circuit (1) comprises at least two amplifier stages (10, 11) and a cross-fading stage (12),
- the amplifier stages (10; 11) in each case comprise an amplifier control input (Vst0; Vst1), an input terminal in each case connected to an amplifier input (VE0; VE1) and an output terminal connected to an amplifier output (A),
- the cross-fading stage (12) comprises at least two cross-fading outputs, in each case connected to an amplifier control input (Vst0; Vst1) of the amplifier stages (10; 11), and at least two cross-fading inputs (ÜE0; ÜE1) in each case connected to a control terminal (St0; St1).

7. A circuit arrangement according to Claim 6, characterised in that
- the input circuit (2) comprises at least two networks (20; 21) each having an input terminal and an output terminal,
- the input terminals of the networks (20, 21) of the input circuit (2) are connected to one another at the input terminal (E) of the input circuit (2),
- an output terminal of the networks (20; 21) is in each case connected to an amplifier input (VE0; VE1) in each case at an output terminal (RA0; RA1) of the input circuit.

8. A circuit arrangement according to Claim 6,
characterised in that the cross-fading stage (12) has the form of a differential amplifier stage.

9. A circuit arrangement according to Claim 8,
characterised in that the cross-fading stage (12) can be controlled by the current flowing into the input circuit (2) at the input terminal (E).

10. A circuit arrangement according to one of Claims 6 or 8, characterised in that the cross-fading stage (12) can be controlled by at least one digitally generated control signal.

11. A circuit arrangement according to one of the preceding claims, characterised in that the networks (20, 21) of the input circuit (2) have the form of side-tone networks of a telephone circuit, and the circuit arrangement is used as receiving amplifier in a telephone circuit.

## Revendications

1. Montage comportant :
- un circuit amplificateur (1) à amplification réglable, qui comporte au moins une entrée (VE0, VE1), au moins une sortie (A) et au moins une borne de commande (St0, St1) pour régler l'amplification,
- un circuit d'entrée (2) comportant une borne d'entrée (U1) et au moins une borne de sortie (RA0, RA1) et qui est relié par l'intermédiaire d'au moins une borne de sortie (RA0, RA1) à une entrée respective (VE0, VE1) du circuit amplificateur (1),
- un circuit de commande (3), qui comporte au moins une sortie de commande (St), qui est reliée à au moins une borne de commande (St0) du circuit amplificateur (1) et à laquelle est appliqué un courant de commande servant à régler l'amplification du circuit amplificateur (1), et qui comporte au moins une entrée de référence (RE) et des entrées numériques de commande (DE0, DE1, DE2, DE3),
caractérisé en ce que
le circuit de commande (3) est agencé à la manière d'un circuit formant miroir de courant possédant l'entrée de référence (RE) en tant qu'entrée pour un courant de référence et comportant au moins une sortie de commande (St) en tant que sortie pour le courant de commande, et qui comporte une branche de référence (300) reliée à l'entrée de référence (RE), une branche de miroir (310) reliée à au moins une sortie de commande (St) et une branche de commande (301, 302, 303, 311) branchée en parallèle avec la branche de référence (300) ou la branche de miroir (310), et que dans la au moins une branche de commande (301, 302, 303, 311) et dans la branche de miroir (310) est prévue respectivement une source de courant de miroir (M₂ ... M₆) commandée par la branche de référence (300) et servant à produire respectivement un courant proportionnel au courant de référence, et que la source de courant de miroir (M₂ ... M₆) de la au moins une branche de commande (302, 303, 311) peut être branchée et débranchée par l'intermédiaire d'une entrée numérique de commande (DE0 ... DE3) du circuit de commande (3).

2. Montage selon la revendication 1, caractérisé en ce que le circuit de commande (3) comporte plusieurs branches de commande (301, 302, 303, 311), dont quelques-unes sont branchées en parallèle avec la branche de référence (300) tandis que les autres sont branchées en parallèle avec la branche de miroir (310).

3. Montage selon la revendication 1 ou 2, caractérisé en ce que
- la branche de référence (300) comporte un transistor de puits de courant (M₁) branché en tant que puits de courant de miroir du circuit formant miroir de courant,
- la branche de miroir (310) possède un transistor formant source de courant (M₆) branché en tant que source de courant de miroir du circuit formant miroir de courant,
- chaque branche de courant (301 ou 302 ou 303 ou 311) comporte un transistor de commutation (M₇ ou M₈ ou M₉ ou M₁₀), en aval duquel est branché un transistor formant source de courant (M₂ ou M₃ ou M₄ ou M₅) agencé sous la forme d'une source de courant de miroir du circuit formant miroir de courant.

4. Montage selon la revendication 3, caractérisé en ce que les transistors (M₁, M₂, M₃, M₅, M₆, M₇, M₈, M₉ ou M₁₀) de la branche de référence (300), des branches de commande (301, 302, 303, 311) et de la branche de miroir (310) sont agencées sous la forme de transistors MOS.

5. Montage selon l'une des revendications précédentes, caractérisé en ce que
- le circuit amplificateur (1) comporte un étage amplificateur (10) possédant une borne d'entrée, qui est réalisée sous la forme d'une entrée (VE) du circuit amplificateur (1), une entrée (Vst) de commande de l'amplificateur, agencée sous la forme d'une borne de commande (St0) du circuit amplificateur (1), et une borne de sortie réalisée sous la forme d'une sortie (A) du circuit amplificateur (1), et
- le circuit d'entrée (2) comporte un réseau (20) possédant une borne d'entrée réalisée sous la forme d'une borne d'entrée (E) du circuit d'entrée (2), et une borne de sortie réalisée sous la forme d'une borne de sortie (RA0) du circuit d'entrée (2).

6. Montage selon l'une des revendications 1 à 4, caractérisé en ce que
- le circuit amplificateur (1) comporte au moins deux étages amplificateurs (10, 11) et un étage mélangeur (12),
- les étages amplificateurs (10 et 11) comportent chacun une entrée de commande (Vst0 et Vst1), respectivement une borne d'entrée reliée à une entrée respective d'amplificateur (VE0 ou VE1) et respectivement une borne de sortie reliée à une sortie d'amplificateur (A),
- l'étage mélangeur (12) comporte au moins deux sorties de mélange, qui sont reliées respectivement à une entrée (Vst0 ou Vst1) des étages amplificateurs (10 et 11), et au moins deux entrées de mélange (ÜE0 et ÜE1) reliées à une borne respective de commande (St0 et St1).

7. Montage selon la revendication 6, caractérisé en ce que
- le circuit d'entrée (2) comporte au moins deux réseaux (20 ou 21) possédant chacun une borne d'entrée et comportant chacun une borne de sortie,
- les bornes d'entrée des réseaux (20, 21) du circuit d'entrée (2) sont reliées entre elles au niveau de la borne d'entrée (M) du circuit d'entrée (2),
- respectivement une borne de sortie des réseaux (20 et 21) est reliée, respectivement au niveau d'une borne de sortie (RA0 ou RA1) du circuit d'entrée, à une entrée
respective d'amplificateur (VE0 ou VE1).

8. Montage selon la revendication 6, caractérisé en ce que l'étage mélangeur (12) est agencé sous la forme d'un étage amplificateur différentiel.

9. Montage selon la revendication 8, caractérisé en ce que l'étage mélangeur (12) peut être commandé par le courant qui pénètre, au niveau de la borne d'entrée (E), dans le circuit d'entrée (2).

10. Montage selon l'une des revendications 6 ou 8, caractérisé en ce que l'étage mélangeur (12) peut être commandé par au moins un signal de commande produit numériquement.

11. Montage selon l'une des revendications précédentes, caractérisé en ce que les réseaux (20, 21) du circuit d'entrée (2) sont agencés sous la forme de réseaux d'effet local d'un circuit téléphonique, et que le montage est utilisé en qu'amplificateur de réception dans un circuit téléphonique.
